(19) **Europäisches Patentamt European Patent Office Office européen des brevets**

(11) **EP 3 513 149 B1**

(12) **FASCICULE DE BREVET EUROPEEN**

(45) Date de publication et mention de la délivrance du brevet:
**29.10.2025 Bulletin 2025/44**

(21) Numéro de dépôt: **17784347.1**

(22) Date de dépôt: **12.09.2017**

(51) Classification Internationale des Brevets (IPC):
***G01D 5/245*** *(2006.01)*

(52) Classification Coopérative des Brevets (CPC):
**G01D 5/2451;** G01D 2205/773

(86) Numéro de dépôt international:
**PCT/FR2017/052431**

(87) Numéro de publication internationale:
**WO 2018/051011 (22.03.2018 Gazette 2018/12)**

(54) **SYSTÈME DE DÉTERMINATION D'AU MOINS UN PARAMÈTRE DE ROTATION D'UN ORGANE TOURNANT**

VORRICHTUNG ZUR BESTIMMUNG VON MINDESTENS EINEM ROTATIONSPARAMETER EINES ROTATIONSELEMENTS

SYSTEM FOR DETERMINING AT LEAST ONE ROTATION PARAMETER OF A ROTATING MEMBER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.09.2016 FR 1658522**

(43) Date de publication de la demande:
**24.07.2019 Bulletin 2019/30**

(73) Titulaire: **NTN Europe**
**74000 Annecy (FR)**

(72) Inventeurs:
• **DURET, Christophe**
**74290 Bluffy (FR)**
• **FLAMMIER, Cécile**
**74000 Annecy (FR)**

(74) Mandataire: **Sayettat, Julien Christian**
**Strato-IP**
**63, Boulevard de Ménilmontant**
**75011 Paris (FR)**

(56) Documents cités:
EP-A1- 0 927 872     DE-A1- 10 309 027
FR-A1- 2 955 669     JP-A- 2009 168 679

**Description**

L'invention concerne un système de détermination d'au moins un paramètre de rotation d'un organe tournant, ledit système comprenant un codeur émettant un signal magnétique périodique ainsi qu'un capteur de rotation apte à détecter ledit champ magnétique.

Dans de nombreuses applications, on souhaite connaître en temps réel et avec une qualité optimale au moins un paramètre de rotation d'un organe tournant, tel que sa position, sa vitesse, son accélération ou son sens de déplacement.

Pour ce faire, le document WO-2006/064169 propose l'utilisation d'un codeur destiné à être solidaire de l'organe mobile et sur lequel est formée une piste magnétique qui est apte à émettre un champ magnétique pseudo sinusoïdal à distance de lecture d'un capteur comprenant plusieurs éléments sensibles.

De façon avantageuse, chaque élément sensible peut comprendre au moins un motif à base d'un matériau magnétorésistif à effet tunnel (TMR en anglais pour Tunnel MagnetoResistance) dont la résistance varie en fonction du champ magnétique détecté, tel que par exemple décrit dans le document WO-2004/083881.

Pour déterminer un paramètre de déplacement de l'organe mobile en fonction de l'évolution du champ magnétique détecté, le document WO-2006/064169 prévoit une combinaison des signaux représentatifs de la résistance de chacun des éléments sensibles afin de délivrer deux signaux en quadrature et de même amplitude qui peuvent être utilisés pour calculer ledit paramètre.

En particulier, le codeur comprend une succession alternée de pôles Nord et Sud définissant une largeur polaire $L_p = \dfrac{\pi R}{Npp}$ constante le long du rayon R de lecture pour un nombre $N_{pp}$ de paires de pôles donné, les éléments sensibles étant équirépartis d'une distance $\dfrac{Lp}{2}$ pour pouvoir délivrer les signaux en quadrature.

Dans certaines applications, le codeur doit présenter un faible nombre de paires de pôles, typiquement inférieur à 6, de sorte que sa largeur polaire $L_p$ devient importante, notamment de l'ordre de la dizaine de millimètres.

Toutefois, ces pôles larges délivrent un signal magnétique dont la sinusoïdalité est mauvaise à faible entrefer de lecture, nécessitant un éloignement des éléments sensibles de la piste magnétique, ce qui va à l'encontre de l'amplitude dudit signal et donc de sa bonne détection par les éléments sensibles.

De plus, des pôles larges nécessitent une épaisseur du codeur elle-aussi plus importante afin de conserver la sinusoïdalité du signal magnétique. Ceci n'est pas favorable à l'intégration du codeur dans des dimensions réduites et complexifie le procédé d'aimantation car une plus grande épaisseur doit être saturée magnétiquement.

On connaît par ailleurs, notamment du document DE-103 09 027, des codeurs dont les transitions magnétiques entre les pôles Nord et Sud s'étendent suivant une spirale d'Archimède, chacune desdites spirales étant répartie sur ledit codeur par rotation successive d'un angle $\dfrac{\pi}{Npp}$.

L'avantage de ce type de codeur est que la largeur polaire $L_p$ de chacun des pôles suivant le rayon dudit codeur devient indépendante du nombre $N_{pp}$ de paires de pôles, pouvant ainsi concilier un faible nombre de pôles avec un positionnement adéquat des éléments sensibles relativement à la sinusoïdalité et à l'amplitude du signal magnétique à détecter.

Toutefois, l'art antérieur propose un positionnement des éléments sensibles suivant le rayon d'un tel codeur, ce qui pose un certain nombre de problèmes.

En particulier, pour satisfaire au compromis entre sinusoïdalité et amplitude, les éléments sensibles sont disposés à une distance d'entrefer de la piste magnétique qui est de l'ordre de $\dfrac{Lp}{2}$. Ainsi, notamment pour ne pas risquer une interaction mécanique entre le capteur fixe et le codeur tournant, la largeur polaire $L_p$ doit être typiquement comprise entre 2 et 6 mm.

Or, pour éviter les effets de bords du champ magnétique délivré par le codeur, les éléments sensibles doivent être positionnés par rapport à la piste magnétique avec au moins une paire de pôles de chaque côté, soit deux $L_p$ de chaque côté en plus de l'encombrement radial nécessaire à la disposition des éléments sensibles.

Il en résulte que le codeur doit présenter une hauteur importante, notamment supérieure à $6.L_p$, hauteur qui peut ne pas être disponible dans certaines intégrations.

Le document EP0927672 divulgue un système de détermination d'au moins un paramètre de rotation d'un organe tournant selon l'état de la technique.

L'invention vise à résoudre les problèmes de l'art antérieur en proposant notamment un système de détermination d'au moins un paramètre de rotation d'un organe tournant, dans lequel le compromis entre la périodicité et l'amplitude du signal magnétique détecté peut être satisfait sans induire de contrainte d'encombrement spécifique pour le codeur délivrant ledit signal, et ce en particulier en relation avec un codeur magnétique à faible nombre de paires de pôles.

A cet effet, l'invention propose un système de détermination d'au moins un paramètre de rotation d'un organe tournant, ledit système comprenant :

- un codeur destiné à être associé en rotation à l'organe tournant de sorte à se déplacer conjointement avec lui, ledit codeur comprenant un corps sur lequel est formée une piste magnétique qui est apte à émettre un signal magnétique périodique représentatif de la rotation dudit codeur, ladite piste présentant une alternance de pôles magnétiques Nord et Sud séparés par i transitions, chacune desdites transitions s'étendant suivant une spirale d'Archimède définie en coordonnées polaires par rapport à l'axe de rotation par l'équation

$$\rho = \frac{Npp.Lp}{\pi}.(\theta + \theta_i)$$, $N_{pp}$ étant le nombre de paires de pôles de la piste magnétique et $L_p$ la largeur polaire de chacun des pôles suivant le rayon dudit codeur, l'angle $\theta_i$ de rotation de la i$^{ème}$ spirale par rapport à la première spirale étant égal à $\frac{\pi}{Npp}.i$

avec i compris entre 0 et $2.N_{pp}$-1 ;

- un capteur de rotation apte à détecter le champ magnétique périodique émis par ledit codeur au moyen de plusieurs éléments sensibles magnétiques, répartis angulairement le long de la piste magnétique en formant entre au moins deux éléments sensibles un angle $\alpha$ qui est agencé pour que les signaux délivrés par lesdits éléments soient en quadrature.

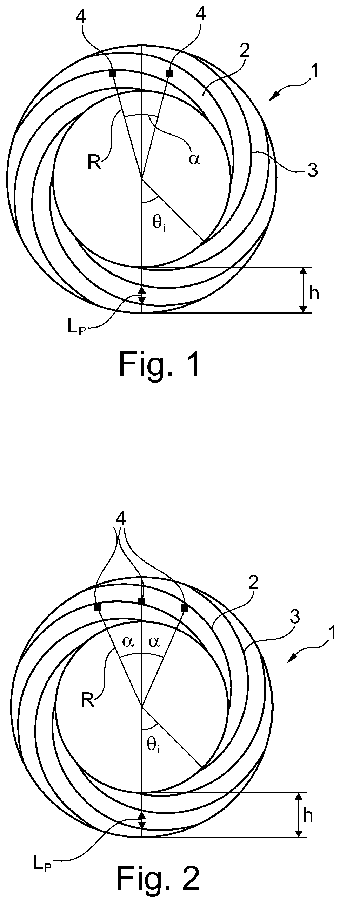

D'autres particularités et avantages de l'invention apparaîtront dans la description qui suit, faite en référence aux figures jointes, dans lesquelles les figures 1 et 2 sont des représentations schématiques d'un système de détermination selon respectivement un mode de réalisation de l'invention, montrant notamment la disposition des éléments sensibles par rapport au codeur.

En relation avec ces figures, on décrit un système de détermination d'au moins un paramètre de rotation d'un organe tournant par rapport à une structure fixe. En particulier, le paramètre de l'organe tournant peut être choisi parmi sa position, sa vitesse, son accélération ou son sens de déplacement.

Dans une application particulière, le système peut être utilisé en relation avec le pilotage d'un moteur électrique à courant continu sans balai, permettant notamment de connaître la position angulaire absolue sur une paire de pôles moteur du rotor par rapport au stator.

Le système de détermination comprend un codeur 1 destiné à être solidaire de l'organe tournant de sorte à se déplacer conjointement avec lui, ledit codeur comprenant un corps, notamment annulaire mais qui peut également être discoïdal, sur lequel est formée une piste magnétique 2 qui est apte à émettre un signal magnétique périodique représentatif de la rotation dudit codeur. En particulier, le signal magnétique émis peut être sinusoïdal ou pseudo-sinusoïdal, c'est-à-dire présentant au moins une portion qui peut être approximée correctement par une sinusoïde.

La piste 2 présente une alternance de pôles magnétiques Nord et Sud qui sont séparés par i transitions 3, chacune desdites transitions s'étendant suivant une spirale d'Archimède définie en coordonnées polaires $(\rho, \theta)$ par rapport à l'axe de rotation par l'équation

$$\rho = \frac{Npp.Lp}{\pi}.(\theta + \theta_i)$$, $N_{pp}$ étant le nombre de paires de pôles de la piste magnétique 2 et $L_p$ la largeur polaire de chacun des pôles suivant le rayon dudit codeur, l'angle $\theta_i$ de rotation de la i$^{ème}$ spirale par rapport à la première spirale étant égal à $\frac{\pi}{Npp}.i$ avec i compris entre 0 et $2.N_{pp}$-1.

Ainsi, la piste magnétique 2 délivre un signal magnétique pseudo sinusoïdal dont la période spatiale est égale à $\lambda = 2.L_p$. En outre, la géométrie en spirale d'Archimède permet notamment que le nombre $N_{pp}$ de paires de pôles de la piste magnétique 2 ainsi que la largeur polaire $L_p$ puissent être choisis indépendamment du rayon R de la piste magnétique 2.

Selon une réalisation, le codeur 1 est formé d'un aimant sur lequel la piste magnétique multipolaire 2 est réalisée. En particulier, l'aimant peut être formé d'une matrice annulaire, par exemple réalisée à base d'un matériau plastique ou élastomère, dans laquelle sont dispersées des particules magnétiques, notamment des particules de ferrite ou de terres rares comme le NdFeB.

Le système de détermination comprend un capteur de rotation qui est destiné à être solidaire de la structure fixe, ledit capteur étant apte à détecter le champ magnétique périodique émis par le codeur 1. Pour ce faire, le capteur comprend plusieurs éléments sensibles magnétiques 4 qui sont disposés à entrefer de lecture du champ magnétique délivré par la piste magnétique 2, chacun des éléments sensibles pouvant notamment être choisi parmi les sondes magnétosensibles.

Par exemple, des sondes à base de magnétorésistances à effet tunnel (TMR), de magnétorésistances anisotropes (AMR) ou de magnétorésistances géantes (GMR) peuvent mesurer une composante du champ magnétique (normale ou tangentielle au codeur) ou le champ tournant (résultant des composantes normales et tangentielles).

En particulier, comme décrit dans le document WO-2004/083881, chaque motif forme une jonction tunnel en comprenant un empilement d'une couche magnétique de référence, d'une couche de séparation isolante et d'une couche magnétique sensible au champ à détecter, la résistance de l'empilement étant fonction de l'orientation relative de l'aimantation des couches magnétiques.

De manière avantageuse, chaque élément sensible 4 peut comprendre au moins un motif à base d'un matériau magnétorésistif dont la résistance varie en fonction du champ magnétique, un élément sensible 4 pouvant comprendre un seul motif ou un groupe de motifs reliés en série.

En variante, la composante normale seule du champ magnétique délivré par le codeur 1 peut être mesurée, par exemple grâce à des éléments à effet Hall. L'utilisation du champ normal seul est favorable car il est plus sinusoïdal que le champ tangentiel.

Pour pouvoir déterminer le paramètre de rotation de l'organe tournant, les signaux délivrés par les éléments sensibles 4 doivent être en quadrature, c'est-à-dire déphasés de 90°. En particulier, par exploitation de tels signaux en quadrature, dans le capteur ou dans un calculateur associé, il est connu de déterminer la position angulaire du codeur 1, par exemple par un calcul direct d'une fonction arctangente, à l'aide d'une « Look-Up Table » (LUT) ou grâce à une méthode de type CORDIC.

Pour ce faire, les éléments sensibles 4 sont répartis angulairement le long de la piste magnétique 2 en formant entre au moins deux éléments sensibles 4 un angle $\alpha$ qui est agencé pour que les signaux délivrés par lesdits éléments soient en quadrature. Selon les modes de réalisation représentés, l'angle $\alpha$ formé entre les deux éléments sensibles 4 est égal à $\frac{\pi}{2Npp}$ modulo $\frac{\pi}{Npp}$.

Ainsi, la répartition circonférentielle des éléments sensibles 4 permet de s'affranchir des effets de bords du champ magnétique délivré par le codeur 1, permettant d'utiliser un codeur 1 de hauteur h limitée, notamment inférieure à $6.L_p$. En particulier, les éléments sensibles 4 peuvent être répartis angulairement suivant un rayon R, notamment le rayon médian sur les figures, de la piste magnétique 2 pour être éloignés au maximum des bords du codeur 1.

En outre, en disposant les éléments sensibles 4 à une distance d'entrefer de lecture de la piste magnétique 2 qui est de l'ordre de $\frac{Lp}{2}$, on obtient un bon compromis entre sinusoïdalité et amplitude du signal détecté. En particulier, ce positionnement optimal peut être obtenu du fait que la largeur polaire $L_p$ peut être comprise entre 2 et 6 mm, et ce même avec un nombre $N_{pp}$ de paires de pôles du codeur 1 qui est inférieur à 6.

Ainsi, la disposition circonférentielle des éléments sensibles 4 présente notamment les avantages suivants :

- la distance entre les deux éléments 4 est suffisamment grande pour utiliser des composants discrets (sondes Hall 1D) peu coûteux et très linéaires ;
- la tolérance de positionnement circonférentiel des éléments 4 impacte peu la précision du capteur (car la distance qui les sépare est grande) ;
- les deux éléments 4 étant situés sur le rayon R milieu du codeur 1, ils sont peu perturbés par les effets de bord ;
- la disposition des éléments sensibles 4 ne dépend pas de la largeur polaire $L_p$ ;
- le rayon R de lecture influence très peu la qualité du signal magnétique.

En relation avec les figures, on décrit ci-dessous un système particulièrement adapté au pilotage d'un moteur électrique à quatre paires de pôles, ledit système fournissant la position absolue sur une paire de pôles moteur, soit 90° mécanique.

Pour ce faire, le codeur 1 comprend 4 paires de pôles ($N_{pp}$ = 4), les éléments sensibles 4 délivrant des signaux en quadrature sur chacune des paires de pôles afin que le capteur ou le calculateur de pilotage du moteur puisse déterminer la position angulaire absolue sur un secteur angulaire de 90°.

En relation avec la figure 1, le capteur comprend deux éléments sensibles 4 formant entre eux un angle $\alpha$ de $\frac{\pi}{2Npp} = 22,5°$. La figure 2 représente un mode de réalisation à trois éléments sensibles 4 séparés deux à deux d'un angle $\alpha$ de 22,5°.

En particulier, cette dernière réalisation permet deux mesures différentielles du champ magnétique délivré (celui de gauche moins celui du centre d'une part, celui du centre moins celui de droite d'autre part). Ainsi, si le champ magnétique comporte une composante de bruit venant de l'extérieur (par exemple du moteur ou des interconnexions voisines) identique sur les différents éléments sensibles 4, celle-ci sera soustraite du signal de sortie.

Du fait de la bonne sinusoïdalité du signal à une distance d'entrefer de lecture de l'ordre de $\frac{Lp}{2}$, le système peut délivrer au calculateur de pilotage du moteur la position angulaire absolue sur une paire de pôles moteur du rotor de façon précise, ce qui permet notamment :

- de meilleures performances, notamment au démarrage, par exemple le temps pour atteindre la consigne de vitesse ou de position ;
- un fonctionnement plus « doux », sans saut de couple en régime établi ;
- une plus faible consommation d'énergie ;
- une température de fonctionnement inférieure ;
- un couple maximum plus important.

## Revendications

1. Système de détermination d'au moins un paramètre de rotation d'un organe tournant, ledit système comprenant :

- un codeur (1) destiné à être associé en rotation à l'organe tournant de sorte à se déplacer conjointement avec lui, ledit codeur comprenant un corps sur lequel est formée une piste magnétique (2) qui est apte à émettre un signal magnétique périodique représentatif de la rotation dudit codeur, ladite piste présentant une alternance de pôles magnétiques Nord et Sud séparés par i transitions (3), chacune desdites transitions s'étendant suivant une spirale d'Archimède définie en coordonnées polaires par rapport à l'axe de rotation par l'équation

$$\rho = \frac{Npp.Lp}{\pi}.(\theta + \theta_i)$$ , N$_{pp}$ étant le nombre de paires de pôles de la piste magnétique (2) et L$_p$ la largeur polaire de chacun des pôles suivant le rayon dudit codeur, l'angle $\theta_i$ de rotation de la i$^{ème}$ spirale par rapport à la première spirale étant égal à $\frac{\pi}{Npp}.i$ avec i compris entre 0 et 2.N$_{pp}$-1 ;
- un capteur de rotation apte à détecter le champ magnétique périodique émis par ledit codeur au moyen de plusieurs éléments sensibles magnétiques (4) ;

ledit système étant **caractérisé en ce que** les éléments sensibles (4) sont répartis angulairement le long de la piste magnétique (2) en formant entre au moins deux éléments sensibles (4) un angle $\alpha$ qui est agencé pour que les signaux délivrés par lesdits éléments soient en quadrature, l'angle $\alpha$ formé entre les deux éléments sensibles étant égal à $\frac{\pi}{2Npp}$ modulo $\frac{\pi}{Npp}$ , les éléments sensibles (4) étant répartis angulairement suivant un rayon R de la piste magnétique (2).

2. Système de détermination selon la revendication 1, **caractérisé en ce que** les éléments sensibles (4) sont répartis angulairement suivant le rayon R médian de la piste magnétique (2).

3. Système de détermination selon l'une des revendications 1 ou 2, **caractérisé en ce que** le capteur comprend deux éléments sensibles (4).

4. Système de détermination selon l'une quelconque des revendications 1 à 3, **caractérisé en ce que** le codeur (1) présente une hauteur qui est inférieure à 6.L$_p$.

5. Système de détermination selon l'une quelconque des revendications 1 à 4, **caractérisé en ce que** les éléments sensibles (4) sont disposés à une distance d'entrefer de lecture de la piste magnétique (2) qui est de l'ordre de $\frac{Lp}{2}$ .

6. Système de détermination selon l'une quelconque des revendications 1 à 5, **caractérisé en ce que** le nombre N$_{pp}$ de paires de pôles du codeur (1) est inférieur à 6.

7. Système de détermination selon l'une quelconque des revendications 1 à 6, **caractérisé en ce que** la largeur polaire L$_p$ du codeur (1) est comprise entre 2 et 6 mm.

**Patentansprüche**

1. Bestimmungssystem mindestens eines Rotationsparameters eines drehenden Organs, wobei das System umfasst :

   - einen Kodierer (1), der bestimmt ist, dem drehenden Organ in Rotation zugeordnet zu sein, sodass er sich gemeinsam mit diesem bewegt, wobei der Kodierer einen Körper umfasst, auf dem eine Magnetbahn (2) ausgebildet ist, die geeignet ist, ein periodisches magnetisches Signal auszusenden, das für die Rotation des Kodierers charakteristisch ist, wobei die Bahn abwechselnd magnetische Nord- und Südpole aufweist, die durch i Übergänge (3) getrennt sind, wobei jeder der Übergänge sich entlang einer archimedischen Spirale erstreckt, die in Polarkoordinaten bezüglich der Rotationsachse durch die Gleichung $\rho = \frac{Npp.Lp}{\pi} * (\theta + \theta_i)$ definiert ist, wobei N$_{pp}$ die Anzahl der Polpaare der Magnetbahn (2) und L$_p$ die Polbreite jedes der Pole entlang des Radius des Kodierers ist, wobei der Winkel $\theta_i$ der Rotation der i$^{ten}$ Spirale in Bezug auf die erste Spirale gleich $\frac{\pi}{Npp} * i$ ist, wobei i zwischen 0 und 2 * N$_{pp}$-1 liegt;
   - einen Rotationssensor, der geeignet ist, das periodische Magnetfeld zu erfassen, das von dem Kodierer mittels mehrerer magnetisch empfindlicher Elemente (4) ausgesendet wird ;

   wobei das System **dadurch gekennzeichnet ist, dass** die empfindlichen Elemente (4) winkelmäßig entlang der Magnetbahn (2) verteilt sind, indem sie zwischen mindestens zwei empfindlichen Elementen (4) einen Winkel $\alpha$ bilden, der angeordnet ist, damit die von den Elementen gelieferten Signale in neunzig Grad Phasenverschiebung sind, wobei der zwischen den beiden empfindlichen Elementen gebildete Winkel $\alpha$ gleich $\frac{\pi}{2Npp}$ modulo $\frac{\pi}{Npp}$ ist, wobei die empfindlichen Elemente (4) winkelmäßig entlang eines Radius R der Magnetbahn (2) verteilt sind.

2. Bestimmungssystem nach Anspruch 1, **dadurch gekennzeichnet, dass** die empfindlichen Elemente (4) entlang des mittleren Radius R der Magnetbahn (2) winkelmäßig verteilt sind.

3. Bestimmungssystem nach einem der Ansprüche 1 oder 2, **dadurch gekennzeichnet, dass** der Sensor zwei empfindliche Elemente (4) umfasst.

4. Bestimmungssystem nach einem der Ansprüche 1 bis 3, **dadurch gekennzeichnet, dass** der Kodierer (1) eine Höhe aufweist, die kleiner als 6 * $L_p$ ist .

5. Bestimmungssystem nach einem der Ansprüche 1 bis 4, **dadurch gekennzeichnet, dass** die empfindlichen Elemente (4) in einem Abstand zum Leseluftspalt der Magnetbahn (2) angeordnet sind, der in der Größenordnung von $\frac{Lp}{2}$ liegt .

6. Bestimmungssystem nach einem der Ansprüche 1 bis 5, **dadurch gekennzeichnet, dass** die Anzahl $N_{pp}$ der Polpaare des Kodierers (1) kleiner als 6 ist.

7. Bestimmungssystem nach einem der Ansprüche 1 bis 6, **dadurch gekennzeichnet, dass** die Polbreite $L_p$ des Kodierers (1) zwischen 2 und 6 mm liegt.

## Claims

1. System for determining at least one rotation parameter of a rotating member, said system comprising:

   - a coder (1) intended to be associated in rotation with the rotating member in such a way as to move together with it, said coder comprising a body on which a magnetic track (2) is formed that is capable of emitting a periodic magnetic signal representative of the rotation of said coder, said track exhibiting an alternation of North and South magnetic poles separated by i transitions (3), each of said transitions extending in an Archimedean spiral defined in polar coordinates with respect to the axis of rotation by the equation $\rho = \frac{Npp.Lp}{\pi}.(\theta + \theta_i)$ , $N_{pp}$ being the number of pairs of poles of the magnetic track (2) and $L_p$ the polar width of each of the poles along the radius of said coder, the angle $\theta_i$ of rotation of the $i^{th}$ spiral with respect to the first spiral being equal to $\frac{\pi}{Npp}.i$ with i between 0 and 2.Npp-1;
   - a rotation sensor able to detect the periodic magnetic field emitted by said coder by means of several magnetic sensitive elements (4);

   said system being **characterised in that** the sensitive elements (4) are distributed angularly along the magnetic track (2) while forming between at least two sensitive elements (4) an angle $\alpha$ which is designed so that the signals delivered by said elements are in quadrature, the angle $\alpha$ formed between the two sensitive elements being equal to

$\frac{\pi}{2Npp}$ modulo $\frac{\pi}{Npp}$. , the sensitive elements (4) being distributed angularly along a radius R of the magnetic track (2).

2. Determination system according to claim 1, **characterised in that** the sensitive elements (4) are distributed angularly according to the median radius R of the magnetic track (2).

3. Determination system according to one of claims 1 or 2, **characterised in that** the sensor comprises two sensitive elements (4).

4. Determination system according to any one of claims 1 to 3, **characterised in that** the coder (1) has a height that is less than 6.$L_p$.

5. Determination system according to any one of claims 1 to 4, **characterised in that** the sensitive elements (4) are disposed at a reading air-gap distance from the magnetic track (2) that is approximately $\frac{Lp}{2}$ .

6. Determination system according to any one of claims 1 to 5, **characterised in that** the number $N_{pp}$ of pairs of poles of the coder (1) is less than 6.

7. Determination system according to any one of claims 1 to 6, **characterised in that** the polar width $L_p$ of the coder (1) is between 2 and 6mm.

Fig. 1

Fig. 2

## RÉFÉRENCES CITÉES DANS LA DESCRIPTION

**Documents brevets cités dans la description**

- WO 2006064169 A
- WO 2004083881 A
- DE 10309027
- EP 0927672 A